(19) Europäisches Patentamt
European Patent Office
Office européen des brevets

(11) **EP 4 507 162 A1**

(12) **EUROPEAN PATENT APPLICATION**
published in accordance with Art. 153(4) EPC

(43) Date of publication:
**12.02.2025 Bulletin 2025/07**

(21) Application number: 23784831.2

(22) Date of filing: **24.04.2023**

(51) International Patent Classification (IPC):
*H02J 7/02* (2016.01)   *B60L 3/00* (2019.01)
*B60L 50/60* (2019.01)   *B60L 58/12* (2019.01)
*B60L 58/16* (2019.01)   *H01M 10/48* (2006.01)
*H02J 7/00* (2006.01)

(52) Cooperative Patent Classification (CPC):
**B60L 3/00; B60L 50/60; B60L 58/12; B60L 58/16;
H01M 10/48; H02J 7/00; H02J 7/02;** Y02E 60/10

(86) International application number:
**PCT/JP2023/016036**

(87) International publication number:
**WO 2023/195548 (12.10.2023 Gazette 2023/41)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **07.04.2022 JP 2022064167**

(71) Applicant: **Vehicle Energy Japan Inc.
Ibaraki 312-8505 (JP)**

(72) Inventor: **NAKAO, Ryohei
Tokyo 100-8280 (JP)**

(74) Representative: **MERH-IP Matias Erny Reichl
Hoffmann
Patentanwälte PartG mbB
Paul-Heyse-Straße 29
80336 München (DE)**

Remarks:
The filing date of the international application is
within two months from the date of expiration of the
priority period (R. 26bis.3 PCT).

(54) **BATTERY CONTROL DEVICE AND BATTERY SYSTEM**

(57)   A battery control device that controls a battery pack in which a plurality of batteries are connected to each other detects a voltage variation between the plurality of batteries, calculates a restriction coefficient based on a charging rate of the battery pack and the voltage variation, and restricts inputtable/outputtable power based on the restriction coefficient, the inputtable/outputtable power being maximum power inputtable to and outputtable from the battery pack.

FIG. 10

(a) CHARGING SIDE

(b) DISCHARGING SIDE

EP 4 507 162 A1

## Description

Technical Field

The present invention relates to a battery control device and a battery system.

Background Art

An electric vehicle system mounted on a vehicle such as an electric vehicle (EV), a plug-in hybrid electric vehicle (PHEV), or a hybrid electric vehicle (HEV) includes a battery that supplies power to a drive source and a battery control device. In order to maximize the performance of the battery, the battery control device detects a voltage, a temperature, and a current of the battery, and based thereon, calculates a state of charge (SOC, charging rate) of the battery, a state of health (SOH, deterioration rate) of the battery, and power that can be input/output when the battery is charged/discharged (inputtable/outputtable power).

Using an upper limit voltage or a lower limit voltage of the battery and an internal resistance of the battery, the inputtable/outputtable power of the battery is calculated as maximum power that can be input and output within a range in which the battery voltage does not deviate from the upper and lower limit voltages. In a multi-series battery system in which a plurality of batteries are connected to one another in series, inputtable/outputtable power is restricted to be around a preset restriction value so that a temperature, an SOC, and a voltage of the battery are within the respective usage ranges when the battery is charged/discharged.

However, if inputtable/outputtable power is restricted using only an average SOC of all the batteries as an index for determining the implementation of the restriction of the inputtable/outputtable power, while all the batteries of the multi-series battery system are regarded as one battery, there are the following disadvantages. That is, in the multi-series battery system, if deterioration progresses in only a specific battery, and its internal resistance increases, resulting in a decrease in capacity, there is a possibility that the specific battery will deviate from its SOC usage range when charged or discharged.

Therefore, Patent Literature 1 discloses a conventional art in which a variation in internal resistance extracted based on a variation in voltage change between batteries when a current flows through the batteries is reflected in calculation of inputtable/outputtable power. According to this conventional art, it is possible to avoid a deviation of a battery from the upper and lower limit voltages that may be caused by a variation in internal resistance between the batteries.

Citation List

Patent Literature

Patent Literature 1: JP 3528428 B2

Summary of Invention

Technical Problem

However, during charging and discharging, where the voltage change caused by the internal resistance greatly changes the SOC at a relatively small current, a small-capacity battery may deviate from its SOC usage range. Therefore, it may be considered to individually estimate an SOC of each battery constituting the multi-series battery system and reflect the SOC of each battery in calculation of inputtable/outputtable power.

However, it is required to provide a temperature sensor for measuring a temperature, which is necessary for estimating an SOC, for each battery, leading to an increase in cost of the battery system and an increase in calculation load.

The present invention has been made in view of the above, and an object of the present invention is to secure the reliability of the battery system by avoiding deviations from the SOC usage range of all the batteries of the battery system while avoiding an increase in cost and an increase in calculation load of the battery system and securing the input/output performance of the batteries.

Solution to Problem

In order to solve the above-described problems of the conventional art, a battery control device according to the present invention is a battery control device that controls a battery pack in which a plurality of batteries are connected to each other, the battery control device detecting a voltage variation between the plurality of batteries; calculating a restriction coefficient based on a charging rate of the battery pack and the voltage variation; and restricting inputtable/outputtable power based on the restriction coefficient, the inputtable/outputtable power being maximum power inputtable to and outputtable from the battery pack.

Advantageous Effects of Invention

According to the present invention, it is possible to secure the reliability of the battery system by avoiding deviations from the SOC usage range of all the batteries of the battery system while avoiding an increase in cost and an increase in calculation load of the battery system and securing the input/output performance of the batteries.

Brief Description of Drawings

Fig. 1 is a block diagram showing an example of a configuration of an electric system of an automobile according to a first embodiment.
Fig. 2 is a block diagram showing an example of a configuration of a unit battery control unit according to the first embodiment.
Fig. 3 is a block diagram showing an example of a configuration of a battery pack control unit according to the first embodiment.
Fig. 4 is a diagram showing an example of a configuration of an SOC table showing a relationship between SOC and OCV.
Fig. 5 is a diagram showing an example of a voltage equivalent circuit model in which a behavior of a voltage of a unit battery is modeled.
Fig. 6 is a diagram showing examples of SOC and voltage waveforms in a case where a battery having a reduced capacity is present in a multi-series battery.
Fig. 7 is a diagram for explaining an example of a method of calculating an input restriction coefficient by a power restriction value calculation unit.
Fig. 8 is a diagram for explaining an example of a method of calculating an output restriction coefficient by the power restriction value calculation unit.
Fig. 9 is a diagram for explaining a problem of power restriction control based on an average SOC.
Fig. 10 is a diagram for explaining an example of an SOC restriction start timing according to a voltage variation in the first embodiment.
Fig. 11 is a diagram for explaining examples of a restriction start point and a restriction end point according to a voltage variation in the first embodiment.
Fig. 12 is a diagram showing examples of power, voltage, SOC, input/output restriction coefficient, and input/output restriction condition waveforms before the first embodiment is applied.
Fig. 13 is a diagram showing examples of power, voltage, SOC, input/output restriction coefficient, and input/output restriction condition waveforms after the first embodiment is applied.
Fig. 14 is a block diagram showing an example of a configuration of a battery pack control unit according to a second embodiment.
Fig. 15 is a diagram showing an example of a voltage variation detection timing according to the second embodiment.
Fig. 16 is a diagram showing examples of current, voltage, SOC, and input/output restriction coefficient waveforms after the second embodiment is applied.
Fig. 17 is a diagram for explaining a problem in detecting a voltage variation.
Fig. 18 is a diagram for explaining an example of a method of determining an input/output restriction condition according to a voltage variation and an SOC in a third embodiment.

Description of Embodiments

Hereinafter, embodiments of the present invention will be described with reference to the drawings. In the following embodiments, a case where the present invention is applied to a battery system constituting a power source of a hybrid vehicle will be described. However, the configurations of the embodiments to be described below are not limited thereto, and can also be applied to a storage battery control circuit or the like of an energy storage apparatus constituting a power source of a passenger vehicle such as a plug-in hybrid vehicle or an electric vehicle, an industrial vehicle such as a hybrid truck, or a railway vehicle.
In the following embodiments, a case where a lithium ion battery is adopted will be described as an example, but a lead battery, a nickel hydrogen battery, a multivalent cation battery, an electric double layer capacitor, a hybrid capacitor, or the like can also be used as long as it is a chargeable/dischargeable secondary battery. In addition, in the following embodiments, a battery pack is configured by connecting a plurality of unit batteries in series, but the present invention can also be applied to a system configured by connecting in series a plurality of battery packs, each including a plurality of unit batteries connected in parallel, or a system configured by connecting in parallel a plurality of battery packs, each including a plurality of unit batteries connected in series.

In the following description, when elements of the same type are described in a distinguished manner, reference numerals with subscripts added to the main body portion are used. When the same kind of elements are described without distinction, only the main body portion excluding subscripts is used as a reference numeral. In addition, in the description of the embodiments, descriptions of configurations and processes that have already been described will be omitted, or descriptions of configurations and processes that are the same as those of the previously described embodiments will be omitted, and differences will be mainly described.

In addition, the number of various components exemplified in the following description is merely an example.

(First Embodiment)

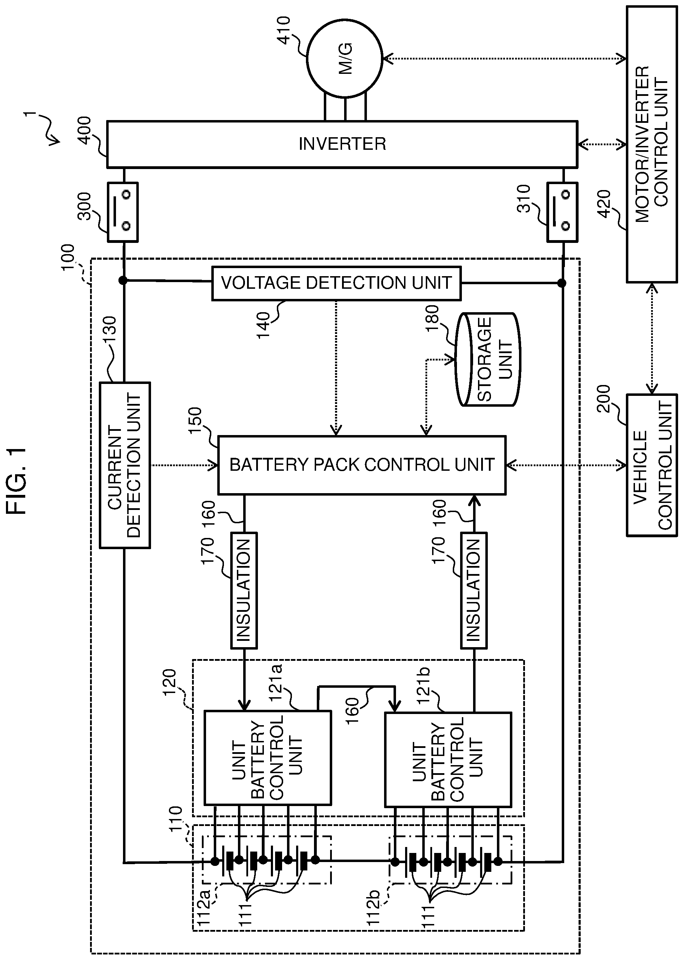

A first embodiment of the present invention will be described with reference to Figs. 1 to 10.

(Configuration of Electric System 1 According to First Embodiment)

Fig. 1 is a block diagram showing an example of a configuration of an electric system 1 of an automobile according to the first embodiment. The electric system 1 in the present embodiment includes a battery system 100, an inverter 400 connected to the battery system 100 via relays 300 and 310, and a motor 410 driven by the inverter 400. A vehicle control unit 200 determines the distribution of the driving force and the like, based on information about the battery system 100 including an SOC, information from the inverter 400 and the motor 410, information about an engine (not shown), and the like.

The battery system 100 includes a battery pack 110, a unit battery management unit 120, a current detection unit 130, a voltage detection unit 140 that detects a total voltage of the battery pack 110, a battery pack control unit 150, and a storage unit 180. The battery pack 110 includes a plurality of unit batteries 111. The unit battery 111 is also referred to as a cell.

The unit battery management unit 120 monitors the state of the unit battery 111. The current detection unit 130 detects a current flowing through the battery system 100. The battery pack control unit 150 controls the battery pack 110. The storage unit 180 stores information regarding battery characteristics of the battery pack 110, the unit battery 111, and the unit battery group 112.

A battery voltage and a temperature of the unit battery 111, a value of a current flowing through the battery, a total voltage value of the battery pack 110, a result of diagnosing whether the unit battery 111 is overcharged or overdischarged, an abnormality signal output in a case where a communication error occurs in the unit battery management unit 120 or the like, etc. are input to the battery pack control unit 150.

The battery voltage and the temperature of the unit battery 111 are output from the unit battery management unit 120. The value of the current flowing through the battery is output from the current detection unit 130. The total voltage value of the battery pack 110 is output from the voltage detection unit 140. The result of diagnosing whether the unit battery 111 is overcharged or overdischarged and the abnormality signal output in a case where the communication error occurs in the unit battery management unit 120 are output from the unit battery management unit 120. The battery pack control unit 150 detects the state of the battery pack 110 and the like based on the input information. The result of the process performed by the battery pack control unit 150 is transmitted to the unit battery management unit 120 and the vehicle control unit 200.

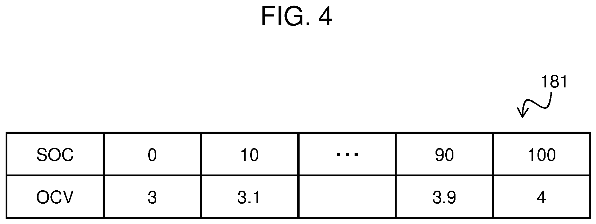

The battery pack 110 is configured by electrically connecting a plurality of unit batteries 111 capable of storing and releasing electric energy (charging and discharging DC power) in series. One unit battery 111 has an output voltage of 3.0 to 4.2 V (average output voltage: 3.6 V). It is assumed that an open circuit voltage (OCV) and a state of charge (SOC) of the unit battery 111 have a correlation shown in Fig. 4. However, the present invention is not limited thereto, and the unit battery 111 may have other voltage specifications.

The unit batteries 111 constituting the battery pack 110 are grouped into a predetermined number of units in order to manage and control the states of the unit batteries 111. The grouped unit batteries 111 are electrically connected to one another in series to constitute a unit battery group 112. The predetermined number of units may be for equal division, such as 1, 4, 6,..., or may be for compound division, such as a combination of 4 and 6.

The unit battery management unit 120 monitors the states of the unit batteries 111 constituting the battery pack 110. The unit battery management unit 120 includes a plurality of unit battery control units 121, and one unit battery control unit 121 is assigned to the unit battery group 112 grouped as described above. The unit battery control unit 121 operates by receiving power from the assigned unit battery group 112, and monitors the battery voltages and temperatures of the unit batteries 111 constituting the unit battery group 112.

In Fig. 1, unit battery control units 121a and 121b are provided to correspond to unit battery groups 112a and 112b.

In the present embodiment, in order to simplify the description, it is assumed that the unit battery group 112 has a configuration in which four unit batteries 111 are electrically connected to one another in series, and the four unit batteries 111 are monitored by one unit battery control unit 121, but the present invention is not limited thereto.

(Configuration of Unit Battery Control Unit 121 According to First Embodiment)

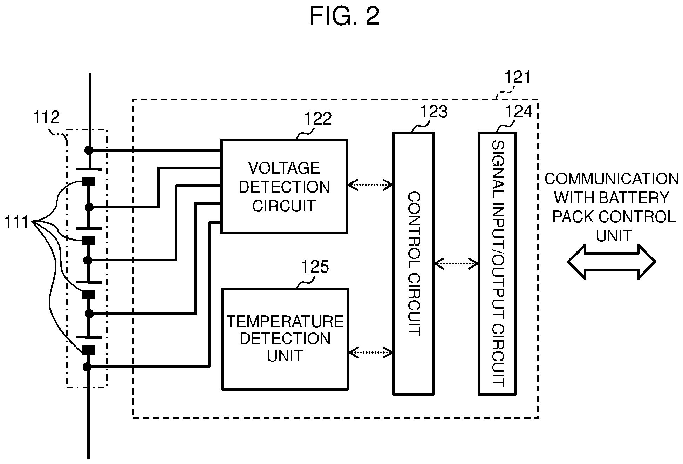

Fig. 2 is a block diagram showing an example of a configuration of the unit battery control unit 121 according to the first embodiment. The unit battery control unit 121 includes a voltage detection circuit 122, a control circuit 123, a signal input/output circuit 124, and a temperature detection unit 125.

The voltage detection circuit 122 measures a voltage between terminals of each unit battery 111. The temperature detection unit 125 measures a temperature of the unit battery group 112. The control circuit 123 transmits measurement results received from the voltage detection circuit 122 and the temperature detection unit 125 to the battery pack control unit 150 via the signal input/output circuit 124. Note that, in the description of the unit battery control unit 121, a circuit configuration for equalizing variations in voltage and SOC between the unit batteries 111 caused by self-discharge, variations in current consumption, and the like is omitted because it is well known.

The temperature detection unit 125 has a function of measuring a temperature of the unit battery group 112. The temperature detection unit 125 measures one temperature as a whole of the unit battery group 112, and treats the measured temperature as a temperature representative value of the unit batteries 111 constituting the unit battery group 112. The temperature measured by the temperature detection unit 125 is used for various calculations for detecting the state of the unit battery 111, the unit battery group 112, or the battery pack 110. Based on this premise, it is shown in Fig. 2 as an example that one temperature detection unit 125 is provided in the unit battery control unit 121. It is also possible to measure a temperature by providing the temperature detection unit 125 for each unit battery 111 and execute various calculations based on the temperature for each unit battery 111, but the large number of temperature detection units 125 complicates the configuration of the unit battery control unit 121.

In Fig. 2, the temperature detection unit 125 is simply shown. In practice, a temperature sensor is installed on an object to be measured, and the temperature sensor outputs temperature information as a voltage. The voltage as a measurement result output from the temperature sensor is transmitted to the signal input/output circuit 124 via the control circuit 123. The signal input/output circuit 124 outputs the measurement result to the outside of the unit battery control unit 121. A function of realizing this series of processes is implemented as the temperature detection unit 125 in the unit battery control unit 121. Temperature information (voltage) can also be measured using the voltage detection circuit 122.

The battery pack control unit 150 and the unit battery management unit 120 transmit and receive signals using a signal communication unit 160 via an insulating element 170 such as photocouplers. The reason why the insulating element 170 is provided is that the battery pack control unit 150 and the unit battery management unit 120 use different operating power sources. That is, the unit battery management unit 120 operates by receiving power from the battery pack 110, whereas the battery pack control unit 150 uses a battery for an in-vehicle accessory (for example, a 12V battery) as a power source. The insulating element 170 may be mounted on a circuit board constituting the unit battery management unit 120, or may be mounted on a circuit board constituting the battery pack control unit 150. Depending on the system configuration, the insulating element 170 may be omitted.

Next, a communication unit between the battery pack control unit 150 and the unit battery control units 121a and 121b in the present embodiment will be described. The unit battery control units 121a and 121b are connected in series in descending order of potential of the unit battery groups 112a and 112b monitored thereby.

The signal output from the battery pack control unit 150 is input to the unit battery control unit 121a by the signal communication unit 160 via the insulating element 170. Similarly, an output of the unit battery control unit 121a and an input of the unit battery control unit 121b are connected by the signal communication unit 160 to transmit a signal. An output of the unit battery control unit 121b is input to the battery pack control unit 150 by the signal communication unit 160 via the insulating element 170.

In this manner, the battery pack control unit 150 and the unit battery control units 121a and 121b are connected in a loop shape by the signal communication unit 160. This loop connection is also referred to as a daisy chain connection, a string connection, or a one-by-one connection.

In the present embodiment, no insulating element 170 is interposed between the unit battery control unit 121a and the unit battery control unit 121b, but an insulating element 170 may be interposed therebetween.

(Configuration of Battery Pack Control Unit 150 According to First Embodiment)

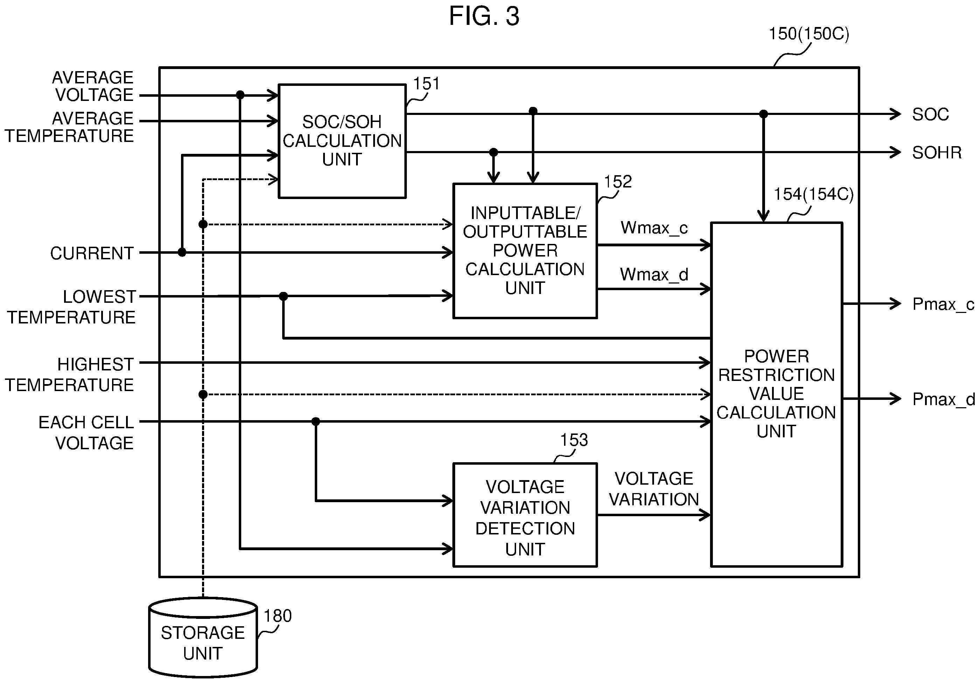

Fig. 3 is a block diagram showing an example of a configuration of the battery pack control unit 150 according to the first embodiment. In the present embodiment, the description of the process based on the diagnosis result related to the unit battery 111 or the abnormality signal output in a case where the communication error occurs in the unit battery management unit 120 is omitted. The battery pack control unit 150 includes an SOC/SOH calculation unit 151, an inputtable/outputtable power calculation unit 152, a voltage variation detection unit 153, and a power restriction value calculation unit 154.

With the average voltage of the unit batteries 111 constituting the battery pack 110, the current flowing through the battery pack 110, and the average temperature of the unit batteries 111 detected by the temperature detection unit 125 as inputs, the SOC/SOH calculation unit 151 calculates and outputs an SOC and an SOH. In the present embodiment, the SOH (deterioration rate) is a state of health based on resistance (SOHR), but may be a state of health based on capacity (SOHC).

With the SOC and the SOHR calculated by the SOC/SOH calculation unit 151, the current of the battery pack 110, and the lowest temperature in the battery system 100 as inputs, the inputtable/outputtable power calculation unit 152 calculates and outputs maximum power (inputtable/outputtable power (inputtable power Wmax_c and outputtable power Wmax_d)) that can be input to and output from the battery.

With the voltage of each unit battery 111 and the average voltage of the unit batteries 111 as inputs, the voltage variation detection unit 153 calculates voltage variation information for each cell, for example, a difference between the highest cell voltage and the average voltage and a difference between the lowest cell voltage and the average voltage, and outputs a voltage variation based thereon.

With the inputtable power Wmax_c and the outputtable power Wmax_d output from the inputtable/outputtable power calculation unit 152, the SOC output from the SOC/SOH calculation unit 151, the lowest temperature and the highest temperature of each cell, the voltage of each cell, and the voltage variation output from the voltage variation detection unit 153 as inputs, the power restriction value calculation unit 154 outputs power restriction values (inputtable power Pmax_c and outputtable power Pmax_d).

The storage unit 180 stores information such as internal resistance characteristics, capacities when fully charged, polarization resistance characteristics, deterioration characteristics, individual difference information, and correspondence relationships between SOC and OCV of the battery pack 110, the unit battery 111, and the unit battery group 112. In the present embodiment, the storage unit 180 is installed outside the battery pack control unit 150 or the unit battery management unit 120, but the battery pack control unit 150 or the unit battery management unit 120 may include a storage unit.

(Configuration of SOC Table 181)

Fig. 4 is a diagram showing an example of a configuration of an SOC table 181 showing a relationship between SOC and OCV. The SOC table 181 is a data table in which a correspondence relationship between OCV and SOC in the unit battery 111 is described for each temperature. Fig. 4 shows correspondence relationships between OCV and SOC at some temperatures, and does not illustrate correspondence relationships between OCV and SOC at other temperatures. The numerical values shown in Fig. 4 are examples, and the smaller the SOC, the smaller the OCV of the battery.

Similarly to the SOC table 181, the storage unit 180 also stores a data table in which correspondence relationships between information on various battery characteristics such as internal resistance characteristics and polarization resistance characteristics and various parameters such as SOC and a temperature are described. In the present embodiment, the correspondence relationship between SOC and OCV is shown in the SOC table 181, but the present invention is not limited to the data table, and the correspondence relationship may be expressed by a formula or the like.

Referring back to Fig. 3, the description will be made. With the battery parameters, the SOC, the SOHR, and the current stored in the storage unit 180, and the lowest temperature in the battery system 100 as inputs, the inputtable/-outputtable power calculation unit 152 calculates maximum currents (inputtable/outputtable currents (an inputtable current Imax_c and an outputtable current Imax_d)) that can be input to and output from the battery, and multiplies the maximum currents by respective battery voltages when the inputtable current is applied, thereby outputting inputtable power Wmax_c and outputtable power Wmax_d.

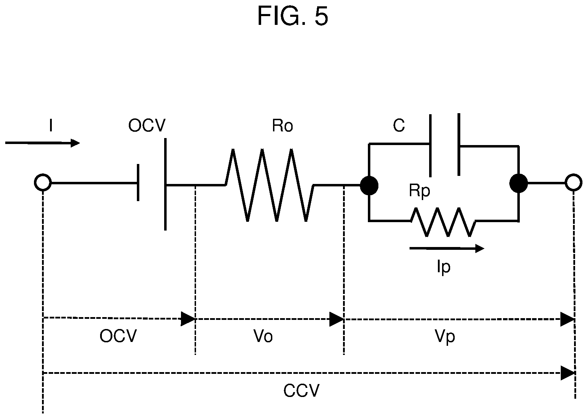

A method of calculating an inputtable current Imax_c and an outputtable current Imax_d by the inputtable/-outputtable power calculation unit 152 will be described with reference to Fig. 5. Fig. 5 is a diagram showing an example of an equivalent circuit model in which the behavior of the voltage of the unit battery 111 is modeled. The equivalent circuit of Fig. 5 has a configuration in which an electromotive force component indicating an OCV of the unit battery 111, a time-independent DC resistance component Ro, and a parallel circuit of a time-dependent polarization resistance component Rp and a capacitor C are connected in series.

The parameters (OCV, Ro, Rp and C) of the equivalent circuit shown in Fig. 5 are extracted from a test result using an actual battery. In the present embodiment, these parameters are extracted from a brand-new battery. Then, each of a DC resistance component Ro_new, which is a time-independent internal resistance component, a polarization resistance component Rp_new, which is a time-dependent internal resistance component, and a polarization time constant $\tau$ (the product of Rp and C) when the battery is brand-new is stored in the storage unit 180 as a map corresponding to the SOC or the temperature.

As shown in Equation (1), a DC resistance component Ro is calculated by reflecting an SOH estimated by the SOC/SOH calculation unit 151 in the DC resistance component Ro_new stored in the storage unit 180. Similarly, as shown in Equation (2), a polarization resistance component Rp is calculated by reflecting an SOH estimated by the SOC/SOH calculation unit 151 in the polarization resistance component Rp_new stored in the storage unit 180.

[Mathematical formula 1]

$$Ro = Ro\_new \times \frac{SOH}{100} \quad \cdots (1)$$

$$Rp = Rp\_new \times \frac{SOH}{100} \quad \cdots (2)$$

In addition, a voltage change Vp caused by the polarization resistance component Rp is calculated as shown in Equation (3) using the polarization resistance component Rp and the polarization time constant $\tau$, with the charge/-discharge time being ts. As shown in Equation (3), the voltage change V caused by the polarization resistance component Rp is obtained as a weighted average of a voltage (I×Rp) and a voltage Vp_z of a capacitor C.
[Mathematical formula 2]

$$Vp = I \times Rp \times \frac{ts}{\tau} + (1 - \frac{ts}{\tau}) \times Vp\_z \quad \cdots (3)$$

Based on the DC resistance component Ro, the polarization resistance component Rp, and the voltage change Vp caused by the polarization resistance component Rp calculated according to the Equations (1) to (3), and $\tau$ stored in the storage unit 180, an inputtable current Imax_c and an outputtable current Imax_d are calculated as shown in Equations (4) and (5).

[Mathematical formula 3]

$$I_{chg} = \frac{Vmax - (OCV(SOC, T) + Vp \times \exp\left(-\frac{tcont}{\tau}\right))}{Ro + Rp \times (1 - \exp\left(-\frac{tcont}{\tau}\right))}$$

$$I_{\max\_c} = \min(I_{chg}, Ilimit)$$

$$\left. \vphantom{\frac{a}{b}} \right\} \cdots (4)$$

$$I_{dis} = \frac{\left(OCV(SOC, T) + Vp \times \exp\left(-\frac{tcont}{\tau}\right)\right) - Vmin}{Ro + Rp \times (1 - \exp\left(-\frac{tcont}{\tau}\right))}$$

$$I_{\max\_d} = \min(I_{dis}, Ilimit)$$

$$\left. \vphantom{\frac{a}{b}} \right\} \cdots (5)$$

Here, in Equations (4) and (5), tcont represents the number of seconds (sec) of continuous current application, Ilimit represents an upper limit current value determined in consideration of a resistance of a relay, a fuse, or the like, which is a component of the battery system 100, Vmax represents an upper limit voltage, and Vmin represents a lower limit voltage. The number of seconds (sec) of continuous current application tcont is the number of seconds set when the current and power that can be continuously applied are defined. For example, in a case where the current or power that can be continuously applied for 5 seconds is calculated, tcont=5 is set.
Next, a method of calculating inputtable/outputtable power using the calculated inputtable current Imax_c and outputtable current Imax_d by the inputtable/outputtable power calculation unit 152 will be described. With the inputtable current Imax_c and outputtable current Imax_d as inputs, the inputtable/outputtable power calculation unit 152 calculates an inputtable maximum power (inputtable power Wmax_c) and an outputtable maximum power (outputtable power Wmax_d) according to Equations (6) and (7). In Equations (6) and (7), N represents the number of cells constituting the battery system 100.

[Mathematical formula 4]

$$W_{\max\_c} = N \times I_{\max\_c} \times \left( OCV + I_{\max\_c} \times (R_0 + Rp \times (1 - \exp\left(-\frac{tcont}{\tau}\right))) + Vp \times \exp\left(-\frac{tcont}{\tau}\right)\right)$$

$$\cdots (6)$$

$$P_{\max\_d} = N \times I_{\max\_d} \times \left( OCV - I_{\max\_d} \times (R_0 + Rp \times (1 - \exp\left(-\frac{tcont}{\tau}\right))) + Vp \times \exp\left(-\frac{tcont}{\tau}\right)\right)$$

$$\cdots (7)$$

(Concerning Voltage Variation Detection Unit 153)

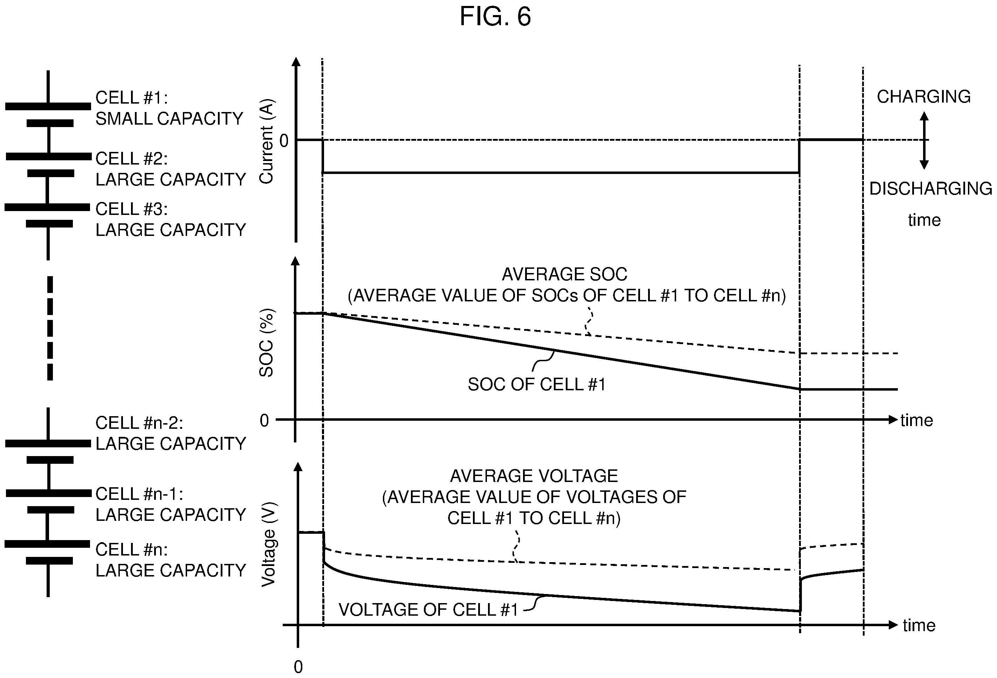

Next, the voltage variation detection unit 153 will be described with reference to Fig. 6. Fig. 6 is a diagram showing examples of SOC and voltage waveforms in a case where a battery having a reduced capacity is present in a multi-series battery. In Fig. 6, as shown on the left side of the diagram, it is assumed that there is one cell #1 whose capacity has deteriorated in the multi-series battery in which a plurality of unit batteries 111 are connected in series. The SOC waveform and the voltage waveform when the current shown in the upper part of Fig. 6 is applied to the multi-series battery are shown in the middle part of Fig. 6 and the lower part of Fig. 6, respectively.

As shown in the middle part of Fig. 6, it can be seen that the SOC of cell #1 decreases below the average SOC of all the cells constituting the multi-series battery, and the voltage of cell #1 also decreases below the average voltage. This is because cell #1 has an increased internal resistance as well as an increased capacity due to deterioration, resulting in a large change in voltage when a current is applied thereto. In addition, this is because the OCV of cell #1, whose SOC is lower than those of the other cells, is reduced, given that a battery generally has an OCV that decreases as the SOC decreases as shown in Fig. 4.

As described above, when a cell having a small capacity is present together in the multi-series battery, a variation in voltage of the battery may occur. Therefore, by detecting a voltage variation of the battery, it is possible to detect that there is a cell in which deterioration has progressed with a small capacity among the cells constituting the multi-series battery. In the present embodiment, for example, an index shown in Equation (8) is adopted as the voltage variation of the battery.

According to Equation (8), the larger one of an absolute value of a difference between the average voltage and the highest voltage of all the cells constituting the multi-series battery and an absolute value of a difference between the average voltage and the lowest voltage of all the cells is output as the voltage variation of the battery. When the voltage variation is larger than or equal to a predetermined value, it is detected that there is a cell having a small capacity among all the cells constituting the multi-series battery. As the voltage variation, either the absolute value of the difference between the average voltage and the highest voltage of all the cells constituting the multi-series battery or the absolute value of the difference between the average voltage and the lowest voltage of all the cells may be used in a fixed manner.

[Mathematical formula 5] voltage variation= Max (|average voltage - highest cell voltage|, |average voltage - lowest cell voltage| (8)

(Concerning Power Restriction Value Calculation Unit 154)

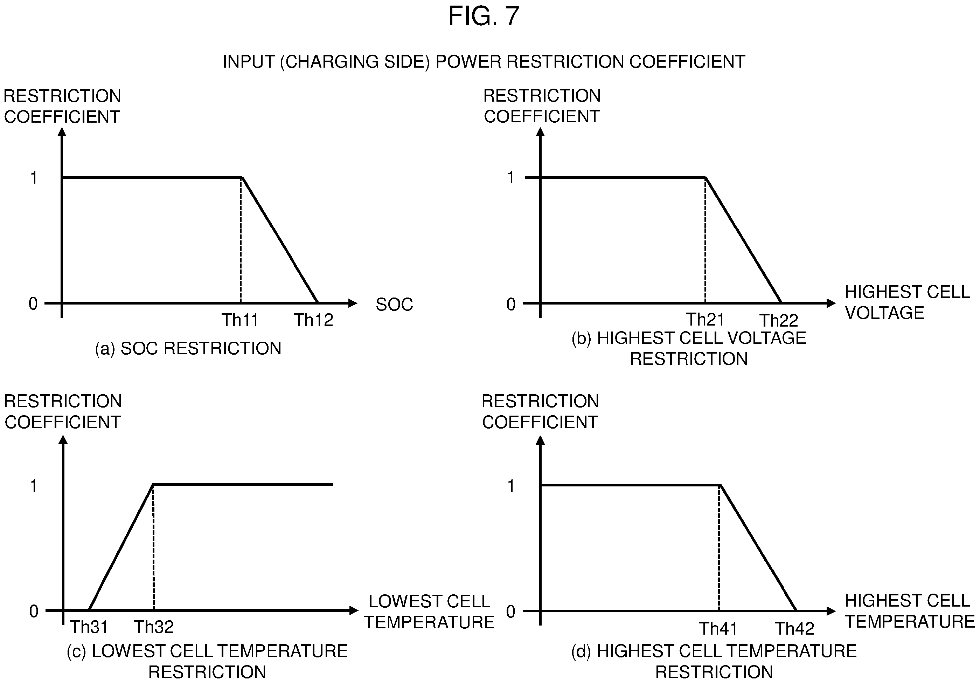

Next, the power restriction value calculation unit 154 will be described with reference to Figs. 7 to 11. The inputtable power Wmax_c and the outputtable power Wmax_d output from the inputtable/outputtable power calculation unit 152, the highest temperature and the lowest temperature of the unit batteries 111 constituting the battery system 100, the voltage of each unit battery 111, the voltage variation detected by the voltage variation detection unit 153, and the SOC are input to the power restriction value calculation unit 154. Then, according to each input value, the power restriction value calculation unit 154 multiplies the inputtable power Wmax_c by an input restriction coefficient kchg (kchg≤1) and multiplies the outputtable power Wmax_d by an output restriction coefficient kdis (kdis≤1) to restrict inputtable/outputtable power. As a result, all the unit batteries 111 are controlled so as not to deviate from the SOC usage range.

Fig. 7 is a diagram for explaining an example of a method of calculating an input restriction coefficient kchg by the power restriction value calculation unit 154. Fig. 7 shows an example of an input restriction coefficient according to each input value for the inputtable power Wmax_c when charged.

Fig. 7(a) shows an input restriction coefficient (first input restriction coefficient) according to the average SOC, and the input restriction coefficient is 1 when the average SOC is lower than or equal to threshold Th11, decreases from 1 at threshold Th11, and is 0 when the average SOC is higher than or equal to threshold Th12.

Fig. 7(b) shows an input restriction coefficient (second input restriction coefficient) according to the highest cell voltage of the cells of the multi-series battery, and the input restriction coefficient is 1 when the highest cell voltage is lower than or equal to threshold Th21, decreases from 1 at threshold Th21, and is 0 when the highest cell voltage is higher than or equal to threshold Th22.

Fig. 7(c) shows an input restriction coefficient (third input restriction coefficient) according to the lowest cell temperature of the cells of the multi-series battery, and the input restriction coefficient is 0 when the lowest cell temperature is lower than or equal to threshold Th31, increases from 0 at threshold Th31, and is 1 when the lowest cell temperature is higher than or equal to threshold Th32.

Fig. 7(d) shows an input restriction coefficient (fourth input restriction coefficient) according to the highest cell temperature of the cells of the multi-series battery, and the input restriction coefficient is 1 when the highest cell temperature is lower than or equal to threshold Th41, decreases from 1 at threshold Th41, and is 0 when the highest cell temperature is higher than or equal to threshold Th42.

The power restriction value calculation unit 154 calculates all the input restriction coefficients according to the respective input values as shown in Figs. 7(a) to 7(d), and sets the smallest value among all the input restriction coefficients as a final input restriction coefficient kchg. As shown in Equation (9), the power restriction value calculation unit 154 multiplies the inputtable power Wmax_c by the input restriction coefficient kchg to calculate and output a final inputtable power Pmax_c.

[Mathematical formula 6]

$$Pmax\_c = kchg \times Wmax\_c \cdots (9)$$

Rather than calculating all the input restriction coefficients shown in Figs. 7(a) to 7(d), only the input restriction coefficient according to the average SOC may be calculated to obtain a final input restriction coefficient kchg.

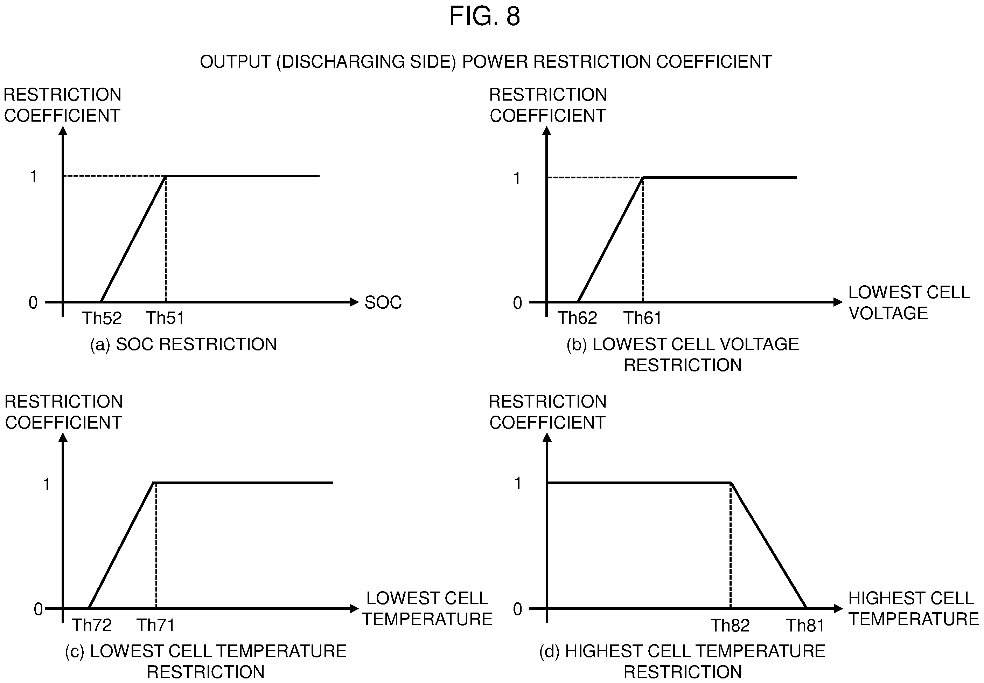

Fig. 8 is a diagram for explaining an example of a method of calculating an output restriction coefficient kdis by the power restriction value calculation unit 154. Fig. 8 shows an example of an output restriction coefficient according to each input value for the outputtable power Wmax_d when discharged.

Fig. 8(a) shows an output restriction coefficient (first output restriction coefficient) according to the average SOC, and the output restriction coefficient is 1 when the average SOC is higher than or equal to threshold Th51, decreases from 1 at threshold Th51, and is 0 when the average SOC is lower than or equal to threshold Th52.

Fig. 8(b) shows an output restriction coefficient (second output restriction coefficient) according to the lowest cell voltage of the cells of the multi-series battery, and the output restriction coefficient is 1 when the lowest cell voltage is higher than or equal to threshold Th61, decreases from 1 at threshold Th61, and is 0 when the lowest cell voltage is lower than or equal to threshold Th62.

Fig. 8(c) shows an output restriction coefficient (third output restriction coefficient) according to the lowest cell temperature of the cells of the multi-series battery, and the output restriction coefficient is 1 when the lowest cell temperature is higher than or equal to threshold Th71, decreases from 1 at threshold Th71, and is 0 when the lowest cell temperature is lower than or equal to threshold Th72.

Fig. 8(d) shows an output restriction coefficient (fourth output restriction coefficient) according to the highest cell temperature of the cells of the multi-series battery, and the output restriction coefficient is 0 when the highest cell temperature is higher than or equal to threshold Th81, decreases from 1 at threshold Th81, and is 0 when the highest cell temperature is lower than or equal to threshold Th82.

The power restriction value calculation unit 154 calculates all the output restriction coefficients according to the respective input values as shown in Figs. 8(a) to 8(d), and sets the smallest value among all the output restriction coefficients as a final output restriction coefficient kdis. As shown in Equation (10), the power restriction value calculation unit 154 multiplies the outputtable power Wmax_d by the output restriction coefficient kdis to calculate and output a final outputtable power Pmax_d.

[Mathematical formula 7]

$$Pmax\_d = kdis \times Wmax\_d \cdots (10)$$

Rather than calculating all the output restriction coefficients shown in Figs. 8(a) to 8(d), only the output restriction coefficient according to the SOC may be calculated to obtain a final output restriction coefficient kdis.

(Method of Calculating Input/Output Restriction Coefficient According to SOC)

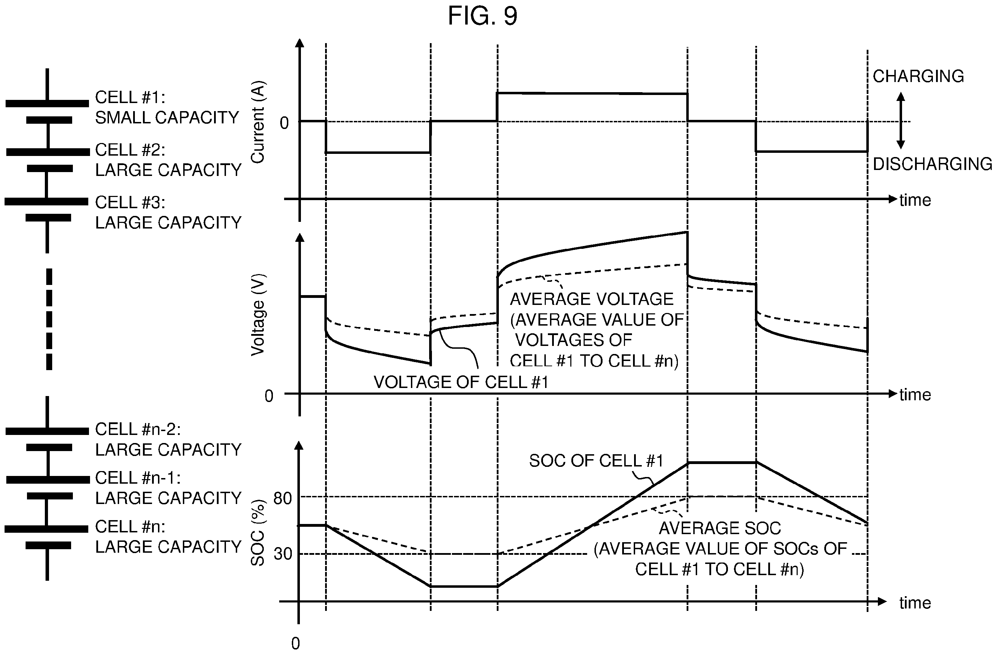

Next, a method of calculating an input/output restriction coefficient according to the SOC in the present embodiment will be described with reference to Figs. 9 to 11.

Fig. 9 is a diagram for explaining a problem of power restriction control based on the average SOC. Fig. 9 shows a voltage waveform (the middle part of Fig. 9) and an SOC waveform (the lower part of Fig. 9) when a current (the upper part of Fig. 9) is input so that an average SOC of the multi-series battery as shown in the lower part of Fig. 9 varies within an SOC usage range, for example, with a lower limit of 30% and an upper limit of 80%, in a case where there is a unit battery 111 (cell #1) having a small capacity among the plurality of batteries constituting the multi-series battery.

Referring to the voltage waveform in the middle part of Fig. 9, the voltage of cell #1 varies more widely up and down than the average voltage of the multi-series battery. Therefore, it can be seen that the SOC of cell #1 deviates from the SOC usage range when the average SOC varies within the SOC usage range with the lower limit of 30% and the upper limit of 80%.

In order to control the SOCs of all the batteries, including an SOC of a battery having a small capacity, not to deviate from the SOC usage range, it may be considered to calculate respective SOCs of the batteries constituting the multi-series battery and adopt an input restriction coefficient (Fig. 7(a)) and the output restriction coefficient (Fig. 8(a)) according to the highest value of the calculated SOCs.

However, in order to calculate an SOC of each battery, it is necessary to install a temperature sensor for measuring a battery temperature in each battery, incurring high cost. Therefore, a restriction method for controlling the SOCs of all the batteries not to deviate from the SOC usage range only using an average SOC without calculating an SOC of each battery will be described.

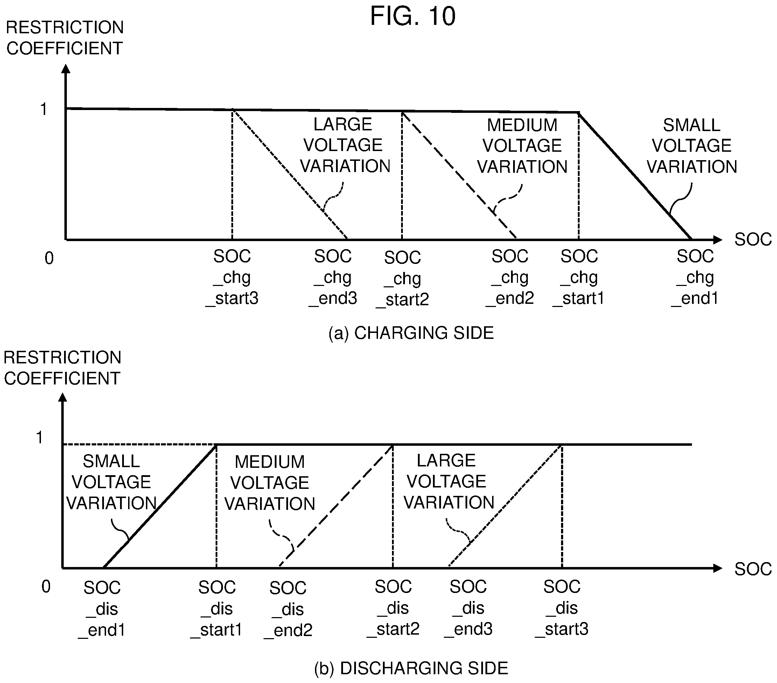

Fig. 10 is a diagram for explaining an example of the SOC restriction start timing according to a voltage variation in the first embodiment. In Fig. 10, the horizontal axis represents an SOC, and the vertical axis represents a restriction coefficient. Fig. 10(a) shows a charging side, that is, an input restriction coefficient according to an SOC, which corresponds to Fig. 7(a). Fig. 10(b) shows a discharging side, that is, an output restriction coefficient according to an SOC, which corresponds to Fig. 8(a).

As shown in Fig. 10(a), during charging, as the voltage variation increases, the restriction start point (the point at which the restriction coefficient starts to decrease) and the restriction end point (the point at which the restriction coefficient decreases to 0) are generally shifted to the left side of the diagram, that is, in a direction in which the SOC decreases. This means that, during charging, the start of the restriction according to the SOC is advanced as the voltage variation between the batteries of the multi-series battery increases.

Specifically, in a case where the voltage variation is small, the input restriction coefficient (first input restriction coefficient) according to the SOC is 1 when the SOC is lower than or equal to SOC_chg_start1, decreases from 1 at SOC_chg_start1, and is 0 when the SOC is higher than or equal to SOC_chg_end1. In a case where the voltage variation is medium, the input restriction coefficient according to the SOC is 1 when the SOC is lower than or equal to SOC_chg_start2, decreases from 1 at SOC_chg_start2, and is 0 when the SOC is higher than or equal to SOC_chg_end2. In a case where the voltage variation is large, the input restriction coefficient according to the SOC is 1 when the SOC is lower than or equal to SOC_chg_start3, decreases from 1 at SOC_chg_start3, and is 0 when the SOC is higher than or equal to SOC_chg_end3.

As shown in Fig. 10(b), during discharging, as the voltage variation increases, the restriction start point (the point at which the restriction coefficient starts to decrease) and the restriction end point (the point at which the restriction coefficient decreases to 1) are generally shifted to the right side of the diagram, that is, in a direction in which the SOC increases. This means that, during discharging, the start of the restriction according to the SOC is advanced as the voltage variation of the cell of the multi-series battery increases.

Specifically, in a case where the voltage variation is small, the output restriction coefficient (first output restriction coefficient) according to the SOC is 1 when the SOC is higher than or equal to SOC_dis_start1, decreases from 1 at SOC_dis_start1, and is 0 when the SOC is lower than or equal to SOC_dis_end1. In a case where the voltage variation is medium, the output restriction coefficient according to the SOC is 1 when the SOC is higher than or equal to SOQ_dis_start2, decreases from 1 at SOQ_dis_start2, and is 0 when the SOC is lower than or equal to SOC_dis_end2. In a case where the voltage variation is large, the output restriction coefficient according to the SOC is 1 when the SOC is higher than or equal to SOC_dis_start3, decreases from 1 at SOC_dis_start3, and is 0 when the SOC is lower than or equal to SOC_dis_end3.

As shown in Figs. 10(a) and 10(b), the greater the voltage variation, the earlier the restriction of the input/output power according to the SOC is started, thereby making it possible to control the inputtable power Wmax_c and the outputtable power Wmax_d such that an SOC of a battery having a small capacity does not deviate from the SOC usage range.

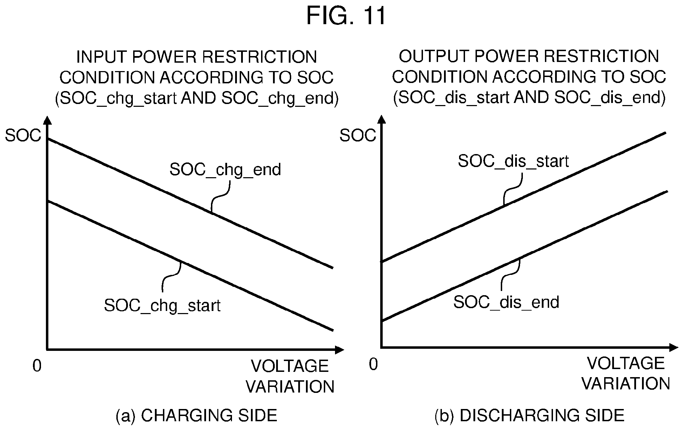

Fig. 11 shows a restriction start point (SOC_chg_start or SOC_dis_start) and a restriction end point (SOC_chg_end or SOC_dis_end) according to the voltage variation on each of the charging side (Fig. 11(a)) and the discharging side (Fig. 11 (b)). In Fig. 11, the horizontal axis represents a voltage variation, and the vertical axis represents an SOC.

As shown in Fig. 11(a), on the charging side, as the voltage variation is larger, SOC_chg_start and SOC_chg_end are set to lower values. As shown in Fig. 11(b), on the discharging side, as the voltage variation is larger, SOC_dis_start and SOC_dis_end are set to higher values. The relationship shown in Fig. 11 is stored in the storage unit 180 as an SOC restriction map for each voltage variation. Referring to the SOC restriction map corresponding to the voltage variation detected by the voltage variation detection unit 153, the power restriction value calculation unit 154 acquires input restriction conditions (SOC_chg_start and SOC_chg_end) and output restriction conditions (SOC_dis_start and SOC_dis_end) according to the SOC, and uses the input restriction conditions and the output restriction conditions for calculating input/output restriction coefficients according to the SOC.

(Effects of First Embodiment)

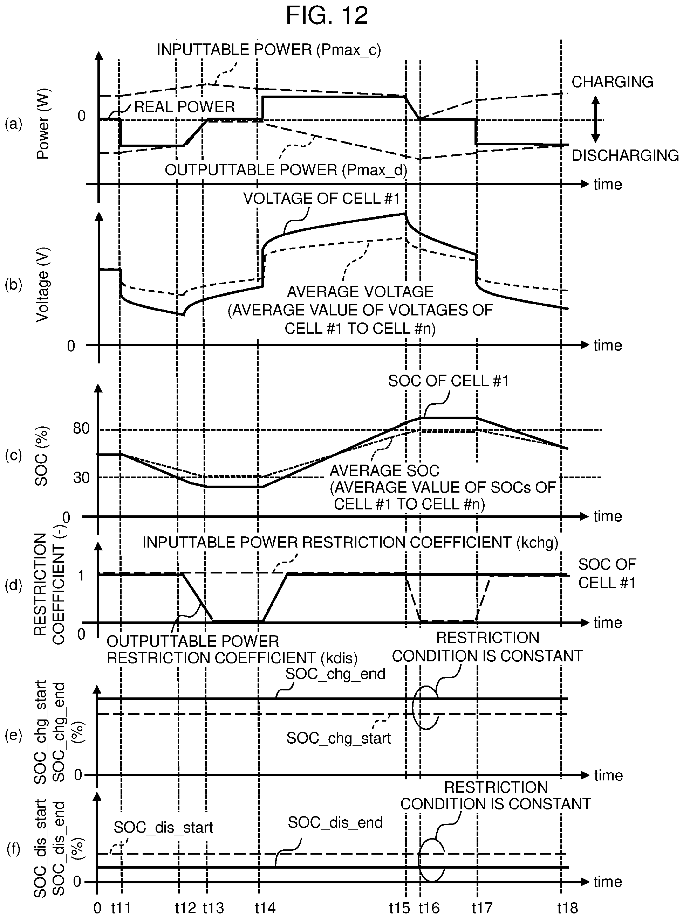

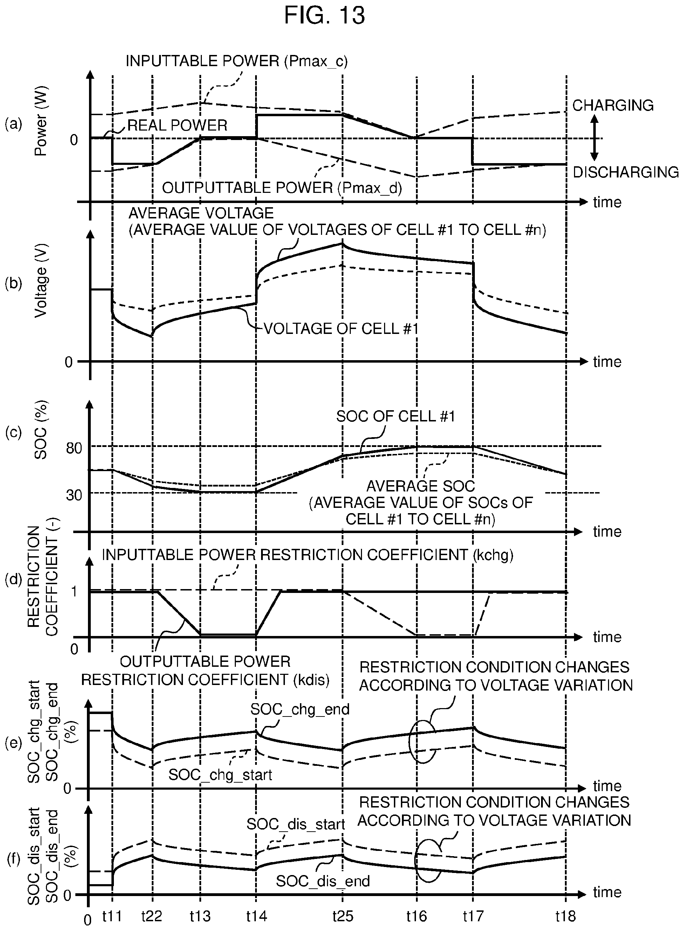

The effects of the present embodiment will be described with reference to Figs. 12 and 13. Fig. 12 is a diagram showing examples of power, voltage, SOC, input/output restriction coefficient, and input/output restriction condition waveforms before the first embodiment is applied. Fig. 13 is a diagram showing examples of power, voltage, SOC, input/output restriction coefficient, and input/output restriction condition waveforms after the first embodiment is applied.

Figs. 12 and 13 show time-series changes of values when a certain load pattern is input to a multi-series battery including a battery (cell #1) having a smaller capacity due to deterioration than the other batteries among the plurality of batteries constituting the multi-series battery.

The values indicating time-series changes in Figs. 12 and 13 are a power, a voltage, an SOC, an input restriction coefficient kchg, an output restriction coefficient kdis, input restriction conditions (SOC_chg_start and SOC_chg_end), and output restriction conditions (SOC_dis_start and SOC_dis_end) of the battery.

As shown in Figs. 12 and 13, the certain load pattern is a pattern in which discharging power is input to the multi-series battery for a predetermined time from time t11 to time t13, a pause period from time t13 to time t14 is set, and then charging power is input to the multi-series battery for a predetermined time from time t14 to time t16. The power waveform input to the multi-series battery is restricted to be within the range between the inputtable power Pmax_c and the outputtable power Pmax_d.

Before the present embodiment is applied, when discharging power is input at time t11 as shown in Fig. 12(a), the battery voltage decreases as the discharging time elapses as shown in Fig. 12(b), and the SOC also decreases as shown in Fig. 12(c). When the average SOC is below threshold SOC_dis_start (Fig. 12(f)) at time t12, the output restriction coefficient kdis decreases from "1" to "0" as shown in Fig. 12(d).

Then, when the average SOC becomes 30%, which is threshold SOC_dis_end (Fig. 12 (f)), at time t13 as shown in Fig. 12(c), the output restriction coefficient kdis becomes "0" as shown in Fig. 12(d). The outputtable power Pmax_d, which is restricted by the output restriction coefficient kdis in Fig. 12(d), decreases from time t12 as shown in Fig. 12(a), and becomes "0" at time t13 when the average SOC becomes 30% (Fig. 12(c)), and the discharging ends.

At this time, referring to Fig. 12(c), it can be seen that the outputtable power can be restricted such that the average SOC is not below 30%, which is the lower limit, but the SOC of cell #1 greatly changes as its capacity is smaller than those of the other cells, and cell #1 is discharged below 30% as the lower limit.

Similarly, when charging power is input at time t14 as shown in Fig. 12(a), the voltage and the SOC increase during charging as shown in Figs. 12(b) and 12(c). When the average SOC is higher than threshold SOC_chg_start (Fig. 12(e)) at time t15, the input restriction coefficient kchg decreases from "1" to "0" as shown in Fig. 12(d).

Then, when the average SOC becomes 80%, which is threshold SOC_chg_end (Fig. 12(e)), at time t16 as shown in Fig. 12(c), the input restriction coefficient kchg becomes "0" as shown in Fig. 12(d). The inputtable power Pmax_c, which is restricted by the input restriction coefficient kchg in Fig. 12(d), decreases from time t15 as shown in Fig. 12(a), and becomes "0" at time t16 when the average SOC becomes 80% (Fig. 12(c)), and the charging ends.

At this time, referring to Fig. 12(c), it can be seen that the battery is charged such that the average SOC is not beyond 80%, which is the upper limit, but the SOC of cell #1 greatly changes as its capacity is smaller than those of the other cells, and cell #1 is charged beyond 80% as the upper limit.

On the other hand, after the present embodiment is applied, the input restriction conditions (SOC_chg_start and SOC_chg_end) and the output restriction conditions (SOC_dis_start and SOC_dis_end) change as shown in Figs. 13(e) and 13(f) based on the relationship between the voltage variation and the input/output restriction conditions according to the SOC shown in Fig. 11. The input restriction coefficient kchg is determined based on the input restriction conditions (SOC_chg_start and SOC_chg_end), and the output restriction coefficient kdis is determined based on the output restriction conditions (SOC_dis_start and SOC_dis_end).

As can be seen from the comparison between Figs. 12(d) and 13(d), the restriction coefficient is set to be smaller than "1" at an earlier timing in the present embodiment than before the present embodiment is applied. That is, the input restriction coefficient kchg is set to be smaller than "1" from the time when the average SOC is lower during charging, and the output restriction coefficient kdis is set to be smaller than "1" from the time when the average SOC is higher during discharging. Accordingly, the inputtable power Pmax_c and the outputtable power Pmax_d also decrease.

That is, as can be seen from Figs. 13(c) and 13(d), on the discharging side, the outputtable power Pmax_d can be controlled so that an SOC of a battery (cell #1) having a small capacity is not below the lower limit, by decreasing the output restriction coefficient kdis calculated based on the average SOC from "1" at time t22 when the SOC is higher than 30% as the lower limit to "0" at time t13. Similarly, on the charging side, the inputtable power Pmax_c can be controlled such that an SOC of a battery (cell #1) having a small capacity is not beyond the upper limit, by decreasing the input restriction coefficient kchg calculated based on the average SOC from "1" at time t25 when the SOC is lower than 80% as the upper limit to "0" at time t16.

In the present embodiment, the input restriction coefficient kchg and the output restriction coefficient kdis based on the average SOC are determined according to the larger one of the absolute values of the differences between the average voltage and the highest and lowest voltages of the cell voltages. As a result, it is possible to calculate inputtable power Pmax_c and outputtable power Pmax_d that prevent an SOC of a battery having the smallest capacity from deviating from the SOC usage range without calculating the SOC of the multi-series battery for each unit battery.

In the present embodiment, it has been described as an example that the inputtable power Pmax_c and the outputtable power Pmax_d are multiplied by the input restriction coefficient kchg and the output restriction coefficient kdis, respectively, but the present invention is not limited thereto. For example, as shown in Equations (11) and (12), results of multiplying the inputtable current Imax_c and the outputtable current Imax_d by the input restriction coefficient kchg and the output restriction coefficient kdis, respectively, may be output instead of the inputtable power Pmax_c and the outputtable power Pmax_d.

[Mathematical formula 8]

$$Imax\_c' = kchg \times Imax\_c \cdots (11)$$

$$Imax\_d' = kdis \times Imax\_d \cdots (12)$$

In the present embodiment described above, a battery control device that controls a battery pack in which a plurality of batteries are connected to each other detects a voltage variation between the plurality of batteries, and restricts inputtable/outputtable power of the battery pack based on a restriction coefficient calculated based on a charging rate (average SOC) of the battery pack and the voltage variation. Therefore, a battery having the lowest capacity among the plurality of batteries can be detected based on the voltage variation, and the restriction coefficient according to the average SOC defining a restriction start point and a restriction end point different depending on the voltage variation can be calculated with a light load. In addition, while the battery pack is charged and discharged, the battery having the smallest capacity in the battery pack can be controlled not to deviate from the SOC usage range.

In the present embodiment, the voltage variation is an index based on a difference between an average voltage and a highest voltage of the plurality of batteries or a difference between the average voltage and a lowest voltage of the plurality of batteries. Therefore, it can be estimated by a simple calculation that there is a battery whose internal resistance increases as its capacity decreases due to deterioration and which deviates from the SOC usage range when charged and discharged among the plurality of batteries.

In addition, in the present embodiment, since the inputtable/outputtable power is restricted by calculating a restriction coefficient of input/output power based on the voltage variation and the average SOC and multiplying the inputtable/outputtable power by the restriction coefficient, the inputtable/outputtable power can be restricted by the calculation with the light load.

In addition, in the present embodiment, the restriction coefficient of the inputtable power according to the average SOC is 1 when the average SOC is lower than or equal to a first threshold, starts to decrease from 1 when the average SOC is the first threshold, becomes 0 when the average SOC is a second threshold larger than a third threshold, and is 0 when the average SOC is higher than or equal to the second threshold, and the first threshold and the second threshold are smaller as the voltage variation is larger. Therefore, the greater the voltage variation, the earlier the restriction of the inputtable power can be implemented in such a manner that the inputtable power decreases from a certain point of time along with the increase in average SOC, and then is set to 0 after a certain point of time.

In the present embodiment, a smallest value among an input restriction coefficient according to an average SOC, an input restriction coefficient according to a highest voltage of the batteries, an input restriction coefficient according to a lowest temperature of the batteries, and an input restriction coefficient according to a highest temperature of the batteries is set as a final input restriction coefficient. Therefore, the inputtable/outputtable power can be restricted to maximize the safety of the battery in terms of four indexes: the average SOC, the highest voltage, the lowest temperature, and the highest temperature.

In addition, in the present embodiment, the restriction coefficient of the outputtable power according to the average SOC is 1 when the average SOC is higher than or equal to a third threshold, starts to decrease from 1 when the average SOC is the third threshold, becomes 0 when the average SOC is a fourth threshold smaller than the third threshold, and is 0 when the average SOC is lower than or equal to the fourth threshold, and the third threshold and the fourth threshold are larger as the voltage variation is larger. Therefore, the greater the voltage variation, the earlier the control of the outputtable power can be implemented in such a manner that the outputtable power decreases from a certain point of time along with the decrease in average SOC, and then is set to 0 after a certain point of time.

In the present embodiment, a smallest value among an output restriction coefficient according to an average SOC, an output restriction coefficient according to a lowest voltage of the batteries, an output restriction coefficient according to a lowest temperature of the batteries, and an output restriction coefficient according to a highest temperature of the batteries is set as a final output restriction coefficient. Therefore, the outputtable power can be restricted to maximize the safety of the battery in terms of four indexes: the average SOC, the highest voltage, the lowest temperature, and the highest temperature.

(Second Embodiment)

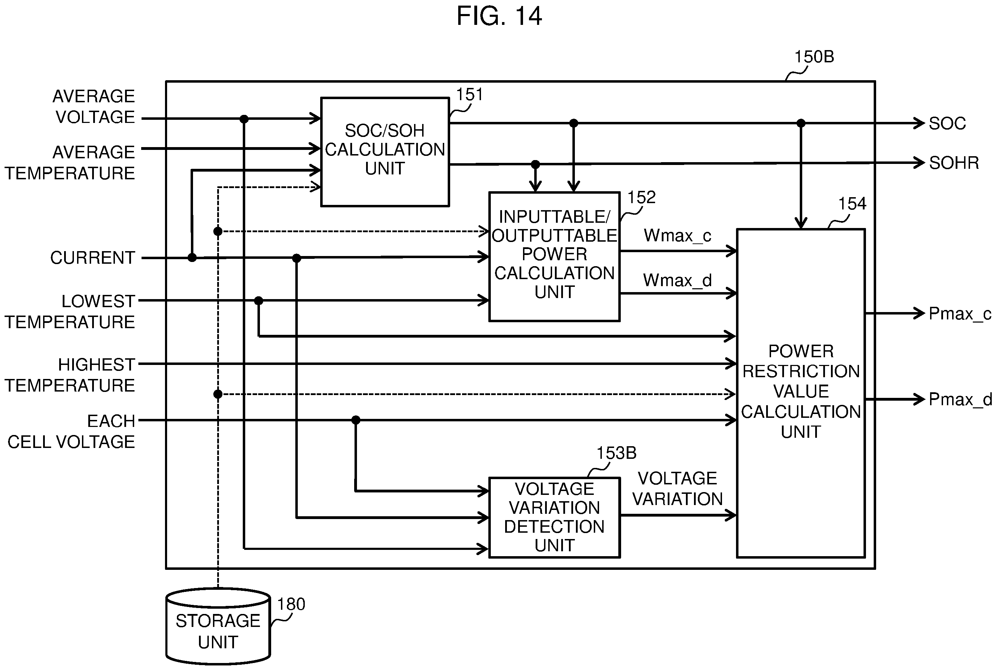

A second embodiment of the present invention will be described with reference to Figs. 14 to 16.

In the first embodiment, using the larger one of absolute values of differences between the largest and smallest values and the average value of the voltages of the batteries constituting the multi-series battery as a voltage variation, and a restriction coefficient of inputtable/outputtable power based on the average SOC is determined according to the voltage variation. Here, in the first embodiment, the condition for detecting the voltage variation is not defined.

An object of the present invention is to detect a variation in SOC between batteries constituting a multi-series battery and prevent an SOC of each battery from deviating from an SOC usage range. Therefore, it is preferable to determine a restriction coefficient of inputtable/outputtable power by detecting a voltage variation under a condition suitable for detecting an SOC variation.

However, since the voltage while a current is applied includes a voltage change due to an internal resistance, the voltage variation including the voltage change does not necessarily match the SOC variation. Therefore, in the present embodiment, a condition for detecting a voltage variation will be described to more accurately treating the voltage variation between the batteries constituting the multi-series battery as an SOC variation.

In the present embodiment, as compared with the first embodiment, the battery system 100 includes a battery pack control unit 150B instead of the battery pack control unit 150. The battery pack control unit 150B includes a voltage variation detection unit 153B instead of the voltage variation detection unit 153.

(Configuration of Battery Pack Control Unit 150B According to Second Embodiment)

First, the battery pack control unit 150B will be described with reference to Fig. 14. Fig. 14 is a block diagram showing an example of a configuration of the battery pack control unit 150B according to the second embodiment. A value of a current flowing through the battery pack 110 is added to the voltage variation detection unit 153B, as compared with the voltage variation detection unit 153 according to the first embodiment.

Since the object of the present invention is to prevent the SOC of each battery constituting the multi-series battery from deviating from the SOC usage range, it is preferable to detect a voltage variation between the batteries under the condition that an SOC variation between the batteries can be detected with high accuracy. Therefore, in the present embodiment, the voltage variation detection unit 153B detects a voltage variation under the condition that the current value added as an input is smaller than or equal to a predetermined value, and determines an input restriction coefficient kchg and an output restriction coefficient kdis.

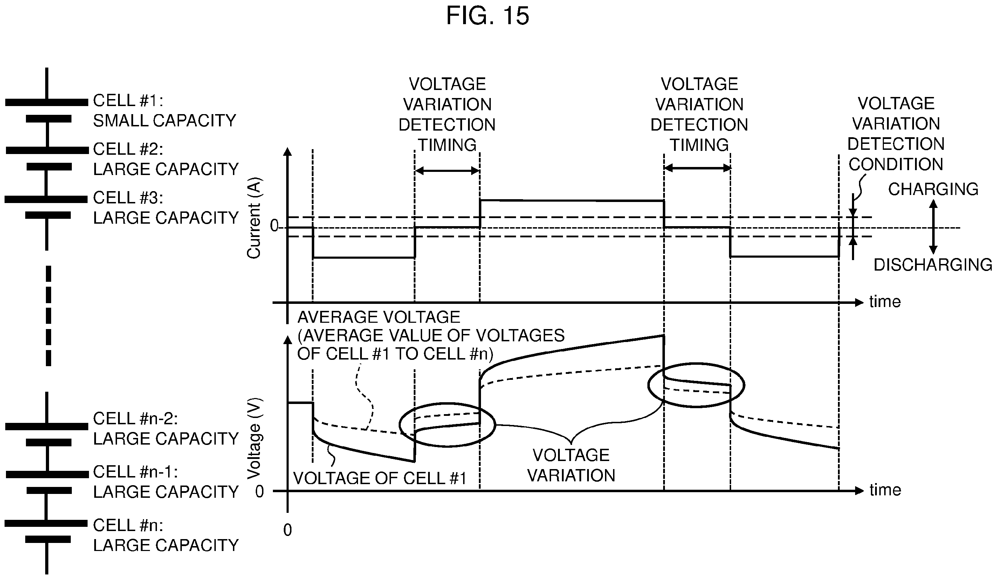

Fig. 15 is a diagram showing an example of a voltage variation detection timing according to the second embodiment. It is assumed that one battery (cell #1) among the plurality of batteries constituting the multi-series battery has a smaller capacity than the other batteries. In the multi-series battery, the SOC of cell #1 greatly changes as compared with those of the other batteries. When discharging is performed for a predetermined time from a state where all the batteries have the same voltage (=OCV) at time 0 when no current flows, the SOC of cell #1 decreases as compared with those of the other batteries. Thereafter, when the discharging is stopped, the voltage approaches the OCV.

As shown in Fig. 4, there is a correlation between OCV and SOC. The voltage variation detected under the condition that the current value is smaller than or equal to the predetermined value is substantially the same as the OCV variation. Therefore, the voltage variation detected under the condition that the current value is smaller than or equal to the predetermined value can be regarded as an SOC variation. In the present embodiment, a voltage variation is detected based on Equation (8) at a voltage variation detection timing satisfying the voltage variation detection condition that the current value is a small value smaller than or equal to the predetermined value. Then, as shown in Figs. 10 and 11, the input/output restriction conditions according to the SOC are determined.

(Effects of Second Embodiment)

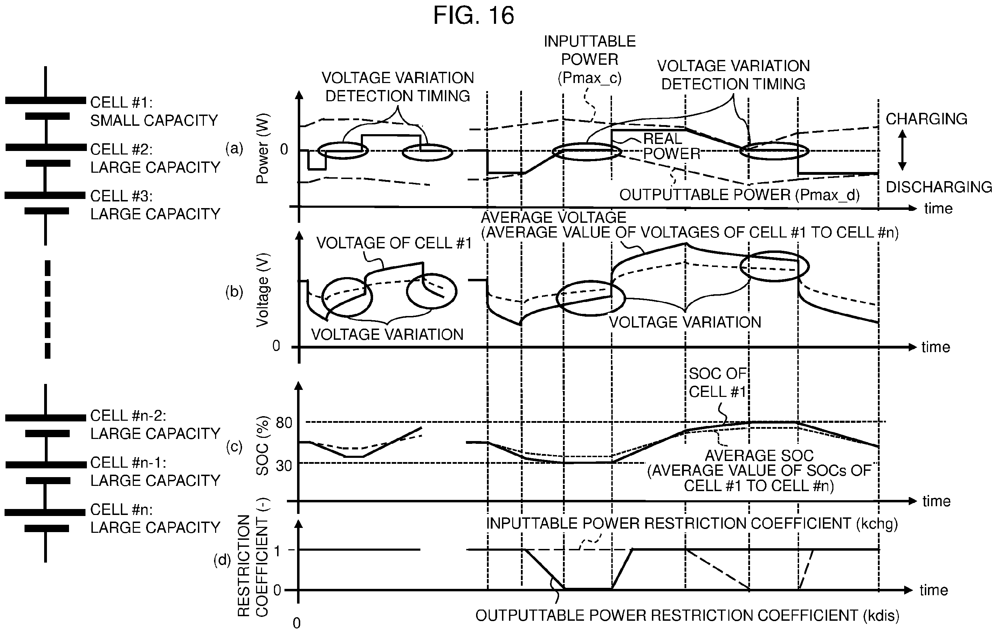

Effects of the present embodiment will be described with reference to Fig. 16. Fig. 16 is a diagram showing examples of current, voltage, SOC, and input/output restriction coefficient waveforms after the second embodiment is applied. Similarly to the diagram (Fig. 13) for explaining the effects of the first embodiment, Fig. 16 shows waveforms when a load pattern in which discharging and charging are repeated is input to a multi-series battery including one small-capacity battery (cell #1).

In the present embodiment, an input restriction coefficient kchg and an output restriction coefficient kdis are determined according to a voltage variation detected during a pause period between discharging in a no-load state in which no current flows and charging as a voltage variation detection timing as shown in Fig. 16(a). Then, similarly to the first embodiment, the inputtable power Pmax_c and the outputtable power Pmax_d are restricted to decrease. As a result, as shown in Fig. 16(c), charging and discharging can be performed so that the SOCs of all the batteries, including cell #1 having a small capacity, do not deviate from the SOC usage range.

According to the present embodiment, it is possible to more accurately evaluate the voltage variation and the SOC variation by detecting the voltage variation when the condition that the current value is smaller than or equal to the predetermined value is satisfied. Then, an input/output restriction coefficient according to the SOC is determined based on the accurate voltage variation. Therefore, it is possible to more accurately calculate inputtable power Pmax_c and outputtable power Pmax_d with which an SOC of a battery having the smallest capacity does not deviate from the SOC usage range.

(Third Embodiment)

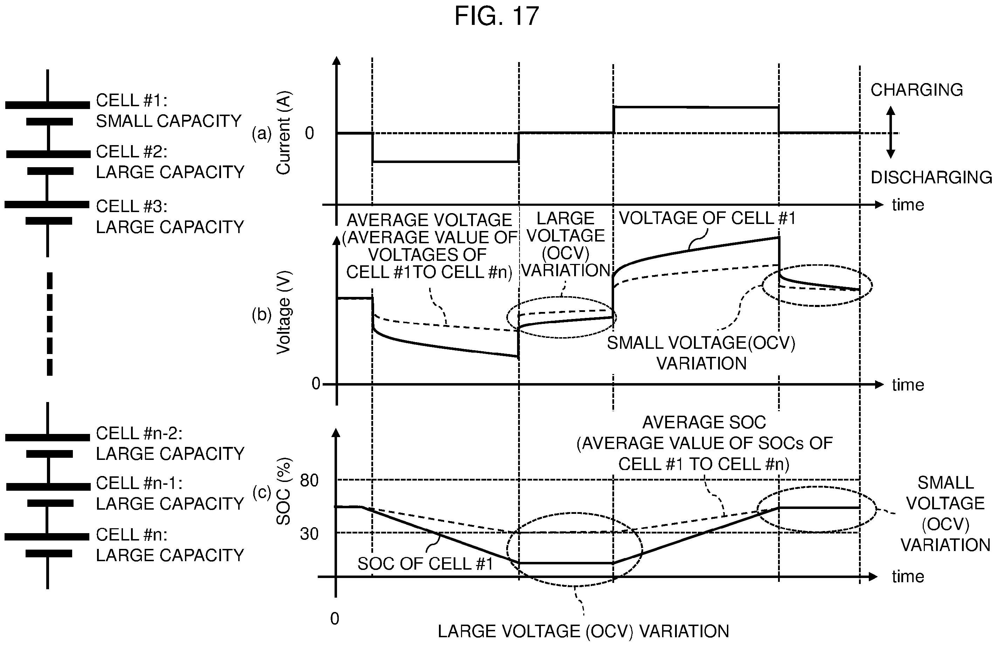

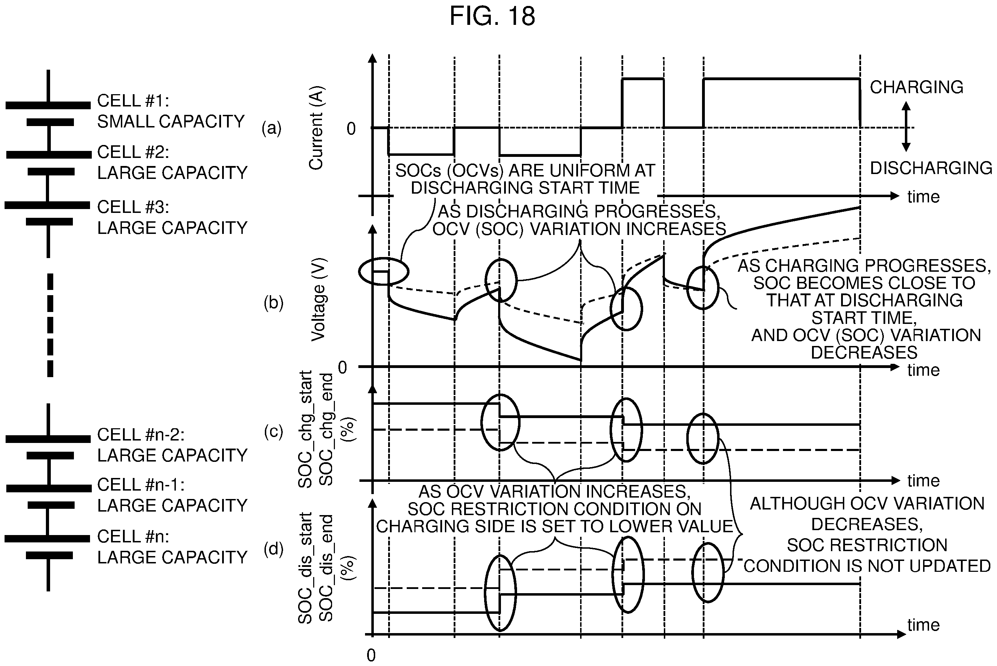

A third embodiment of the present invention will be described with reference to Figs. 17 and 18.

In the second embodiment, a voltage variation, which is a difference between the average voltage and the highest/lowest voltage of the plurality of batteries constituting the multi-series battery, is detected only when the condition that a value of a current flowing through the battery is smaller than or equal to the predetermined value is satisfied. Based on the detected voltage variation, a restriction coefficient of inputtable/outputtable power according to the average SOC is determined.

However, there is always a variation in voltage and SOC between the batteries. The reason will be described with reference to Fig. 17. Fig. 17 is a diagram for explaining a problem in detecting a voltage variation.

Fig. 17(a) shows a current waveform input to the multi-series battery, Fig. 17(b) shows a voltage when the current of Fig. 17(a) is input, and Fig. 17(c) shows an SOC waveform when the current of Fig. 17(a) is input. When discharging is started at a discharging start time immediately after time 0 when the voltage (=OCV) and the SOC are uniform between all batteries, an SOC of a battery having a small capacity changes greatly as compared with those of the other batteries, resulting in a great variation in voltage (=OCV). When the battery is charged from this state until the SOC at the discharging start time is reached, the power balance between charging and discharging becomes "0" with the state in which the voltages and SOCs of all the batteries are uniform at the discharging start time as a reference, and the SOCs return to the uniform state again.

In this manner, with the time point at which the SOCs of all the batteries are uniform as a reference, the greater the change in SOC, the easier it becomes to identify a battery having a small capacity, but the SOCs may appear uniform when the change in SOC is small. For this reason, when a voltage variation is detected, it may be erroneously detected that no SOC variation occurs, that is, there is no small-capacity battery, and the input/output restriction condition according to the SOC may be relaxed.

Therefore, in the present embodiment, an example will be described in which the above-described erroneous detection is prevented by continuously maintaining the input/output restriction condition according to the SOC determined with the largest voltage variation among voltage variations detected after the operation of the battery is started.

The difference of the present embodiment from the first embodiment is that the battery system 100 includes a battery pack control unit 150C instead of the battery pack control unit 150, and the battery pack control unit 150C includes a power restriction value calculation unit 154C instead of the power restriction value calculation unit 154 (Fig. 3). In the battery system 100, only the processing content of the power restriction value calculation unit 154C is different from that of the power restriction value calculation unit 154, and the other configurations are the same.

When a restriction condition is determined using the average SOC according to the voltage variation based on Figs. 10 and 11, the power restriction value calculation unit 154C adopts a currently detected voltage variation only when the currently detected voltage variation is larger than previously detected voltage variations. When the currently detected voltage variation is smaller than the previously detected voltage variations, the largest voltage variation is adopted among the previously detected voltage variations. The previously detected voltage variations are stored in a storage area such as the storage unit 180. As a result, a voltage difference detected under the condition that it is difficult to identify a battery having a small capacity during charging and discharging as described above is not adopted in calculating a voltage variation, thereby making it possible to prevent an erroneous detection that no SOC variation occurs.

Fig. 18 is a diagram for explaining an example of a method of determining an input/output restriction condition according to a voltage variation and an SOC in the third embodiment. Fig. 18(a) shows a current waveform input to the multi-series battery, Fig. 18(b) shows a voltage when a current is input, Fig. 18(c) shows an input restriction condition according to an SOC when the current is input, and Fig. 18(d) shows an output restriction condition according to an SOC.

As shown in Fig. 28(a), a current is input to the battery system 100, from before discharging is started at time 0 when voltages and SOCs are uniform, going through discharging, pausing, discharging, pausing, charging, pausing, and charging. In a case where the method of detecting a voltage difference under the condition that the current value is smaller than or equal to the predetermined value in the second embodiment is applied and the method of determining an input/output restriction condition according to an SOC from a voltage variation immediately before the current is input after pausing is adopted, the input/output restriction condition according to the SOC is determined from a voltage variation detected during a pause period immediately after first-cycle discharging.

During the pause period immediately after the first-cycle discharging, the voltage variation is larger than that at time 0. Therefore, as shown in Fig. 18(c), the input restriction conditions (SOC_chg_start and SOC_chg_end) have smaller values, and as shown in Fig. 18 (d), the output restriction conditions (SOC_dis_start and SOC_dis_end) have larger values. Since the SOC variation and the voltage variation further increase even after second-cycle discharging, the input/output restriction condition according to the voltage variation become stricter.

On the other hand, after a pause period immediately after the second-cycle discharging, when the power balance between charging and discharging decreases as charging progresses, with the SOC in a state where there is no voltage variation at time 0 as a reference, the SOC variation and the voltage variation decrease. When the previously detected voltage variations are larger than a newly detected voltage variation, the newly detected voltage variation is not adopted, the largest one of the previous voltage variations is adopted, and an input/output restriction condition according to the adopted voltage variation is set.

(Effects of Third Embodiment)

According to the present embodiment, an input/output restriction condition determined according to the largest voltage variation among voltage variations detected in time series is continuously maintained. As a result, it is possible to charge and discharge a battery having a small capacity without deviating from the SOC usage range, while preventing an erroneous detection that there is no voltage variation even though there is a voltage variation.

The above description is merely an example, and the present invention is not limited to the configuration of the above-described embodiments, and includes various modifications. For example, the above-described embodiments have been described in detail in order to describe the present invention in an easy-to-understand manner, and are not necessarily limited to those having all the described configurations. In addition, a part of a configuration of a certain embodiment can be replaced with a configuration of another embodiment, and a configuration of a certain embodiment can be added to a configuration of another embodiment. In addition, with respect to a configuration of each embodiment, it is possible to add another configuration, remove the configuration, or replace the configuration with another configuration.

Reference Signs List

| | |
|---|---|
| 100 | Battery system |
| 110 | Battery pack |
| 111 | Unit battery |
| 112 | Unit battery group |
| 120 | Unit battery management unit |
| 121 | Unit battery control unit |
| 122 | Voltage detection circuit |
| 123 | Control circuit |
| 124 | Signal input/output circuit |
| 125 | Temperature detection unit |
| 130 | Current detection unit |
| 140 | Voltage detection unit |
| 150, 150B, 150C | Battery pack control unit |
| 151 | SOC/SOH calculation unit |
| 152 | Inputtable/outputtable power calculation unit |
| 153, 153B | Voltage variation detection unit |

| 154, 154C | Power restriction value calculation unit |
| 180 | Storage unit |
| 200 | Vehicle control unit |

**Claims**

1. A battery control device that controls a battery pack in which a plurality of batteries are connected to each other, wherein the battery control device is configured to:

   detect a voltage variation between the plurality of batteries;
   calculate a restriction coefficient based on a charging rate of the battery pack and the voltage variation; and
   restrict inputtable/outputtable power based on the restriction coefficient, the inputtable/outputtable power being maximum power inputtable to and outputtable from the battery pack.

2. The battery control device according to claim 1, wherein
   the voltage variation is a difference between an average voltage and a highest voltage of the plurality of batteries or a difference between the average voltage and a lowest voltage of the plurality of batteries.

3. The battery control device according to claim 1 or 2, comprising:

   an inputtable/outputtable power calculation unit configured to calculate the inputtable/outputtable power based on the charging rate, a deterioration rate and a current of the battery pack, and a lowest temperature of the plurality of batteries;
   a voltage variation detection unit configured to detect the voltage variation based on an average voltage of the plurality of batteries and a voltage of each of the plurality of batteries; and
   a power restriction value calculation unit configured to calculate the restriction coefficient based on the voltage variation and the charging rate and restrict the inputtable/outputtable power by multiplying the inputtable/outputtable power by the restriction coefficient.

4. The battery control device according to claim 3, wherein

   the power restriction value calculation unit calculates, as the restriction coefficient, a first input restriction coefficient for restricting inputtable power of the inputtable/outputtable power according to the charging rate, the first input restriction coefficient is 1 when the charging rate is lower than or equal to a first threshold, starts to decrease from 1 when the charging rate is the first threshold, becomes 0 when the charging rate is a second threshold larger than the first threshold, and is 0 when the charging rate is higher than or equal to the second threshold, and
   the first threshold and the second threshold are smaller as the voltage variation is larger.

5. The battery control device according to claim 4, wherein

   the power restriction value calculation unit further calculates a second input restriction coefficient for restricting the inputtable power according to a highest voltage of the plurality of batteries, a third input restriction coefficient for restricting the inputtable power according to a lowest temperature of the plurality of batteries, and a fourth input restriction coefficient for restricting the inputtable power according to a highest temperature of the plurality of batteries, and
   a smallest value of the first input restriction coefficient to the fourth input restriction coefficient is set as the restriction coefficient.

6. The battery control device according to any one of claims 3 to 5, wherein

   the power restriction value calculation unit calculates, as the restriction coefficient, a first output restriction coefficient for restricting outputtable power of the inputtable/outputtable power according to the charging rate, the first output restriction coefficient is 1 when the charging rate is higher than or equal to a third threshold, starts to decrease from 1 when the charging rate is the third threshold, becomes 0 when the charging rate is a fourth threshold smaller than the third threshold, and is 0 when the charging rate is lower than or equal to the fourth threshold, and
   the third threshold and the fourth threshold are larger as the voltage variation is larger.

7. The battery control device according to claim 6, wherein

the power restriction value calculation unit further calculates a second output restriction coefficient for restricting the outputtable power according to a lowest voltage of the plurality of batteries, a third output restriction coefficient for restricting the outputtable power according to a lowest temperature of the plurality of batteries, and a fourth output restriction coefficient for restricting the outputtable power according to a highest temperature of the plurality of batteries, and
a smallest value of the first output restriction coefficient to the fourth output restriction coefficient is set as the restriction coefficient.

8. The battery control device according to any one of claims 1 to 7, wherein
the voltage variation is detected when an absolute value of a current of the battery pack is smaller than or equal to a predetermined value.

9. The battery control device according to any one of claims 1 to 8, wherein
the restriction coefficient is calculated based on a largest value of the voltage variation detected after a time point at which voltages of the plurality of batteries are uniform.

10. A battery system comprising:

the battery pack; and
the battery control device according to any one of claims 1 to 9.

FIG. 1

# FIG. 2

VOLTAGE DETECTION CIRCUIT

TEMPERATURE DETECTION UNIT

CONTROL CIRCUIT

SIGNAL INPUT/OUTPUT CIRCUIT

COMMUNICATION WITH BATTERY PACK CONTROL UNIT

# FIG. 3

EP 4 507 162 A1

# FIG. 4

181

| SOC | 0 | 10 | ... | 90 | 100 |
|---|---|---|---|---|---|
| OCV | 3 | 3.1 | | 3.9 | 4 |

FIG. 5

# FIG. 6

CELL #1:
SMALL CAPACITY

CELL #2:
LARGE CAPACITY

CELL #3:
LARGE CAPACITY

CELL #n-2:
LARGE CAPACITY

CELL #n-1:
LARGE CAPACITY

CELL #n:
LARGE CAPACITY

Current (A)

0

CHARGING

DISCHARGING

time

AVERAGE SOC
(AVERAGE VALUE OF SOCs OF CELL #1 TO CELL #n)

SOC (%)

SOC OF CELL #1

0

time

AVERAGE VOLTAGE
(AVERAGE VALUE OF VOLTAGES OF
CELL #1 TO CELL #n)

Voltage (V)

VOLTAGE OF CELL #1

time

0

EP 4 507 162 A1

# FIG. 7

INPUT (CHARGING SIDE) POWER RESTRICTION COEFFICIENT

(a) SOC RESTRICTION

(b) HIGHEST CELL VOLTAGE RESTRICTION

(c) LOWEST CELL TEMPERATURE RESTRICTION

(d) HIGHEST CELL TEMPERATURE RESTRICTION

EP 4 507 162 A1

# FIG. 8

OUTPUT (DISCHARGING SIDE) POWER RESTRICTION COEFFICIENT

(a) SOC RESTRICTION

(b) LOWEST CELL VOLTAGE RESTRICTION

(c) LOWEST CELL TEMPERATURE RESTRICTION

(d) HIGHEST CELL TEMPERATURE RESTRICTION

EP 4 507 162 A1

# FIG. 9

CELL #1:
SMALL CAPACITY

CELL #2:
LARGE CAPACITY

CELL #3:
LARGE CAPACITY

CELL #n-2:
LARGE CAPACITY

CELL #n-1:
LARGE CAPACITY

CELL #n:
LARGE CAPACITY

Current (A)

CHARGING

0

DISCHARGING

time

Voltage (V)

AVERAGE VOLTAGE
(AVERAGE VALUE OF
VOLTAGES OF
CELL #1 TO CELL #n)

VOLTAGE OF CELL #1

0

time

SOC (%)

SOC OF CELL #1

80

AVERAGE SOC
(AVERAGE VALUE OF SOCs OF
CELL #1 TO CELL #n)

30

0

time

EP 4 507 162 A1

# FIG. 10

(a) CHARGING SIDE

(b) DISCHARGING SIDE

EP 4 507 162 A1

# FIG. 11

INPUT POWER RESTRICTION
CONDITION ACCORDING TO SOC
(SOC_chg_start AND SOC_chg_end)

OUTPUT POWER RESTRICTION
CONDITION ACCORDING TO SOC
(SOC_dis_start AND SOC_dis_end)

SOC

SOC_chg_end

SOC_chg_start

0

VOLTAGE
VARIATION

(a) CHARGING SIDE

SOC

SOC_dis_start

SOC_dis_end

0

VOLTAGE
VARIATION

(b) DISCHARGING SIDE

# FIG. 12

(a) Power (W)

INPUTTABLE POWER (Pmax_c)

REAL POWER

CHARGING

DISCHARGING

OUTPUTTABLE POWER (Pmax_d)

time

(b) Voltage (V)

VOLTAGE OF CELL #1

AVERAGE VOLTAGE
(AVERAGE VALUE OF VOLTAGES OF
CELL #1 TO CELL #n)

time

(c) SOC (%)

SOC OF CELL #1

80

30

AVERAGE SOC
(AVERAGE VALUE OF SOCs OF
CELL #1 TO CELL #n)

time

(d) RESTRICTION COEFFICIENT (-)

INPUTTABLE POWER RESTRICTION COEFFICIENT (kchg)

1

SOC OF
CELL #1

0

OUTPUTTABLE POWER
RESTRICTION COEFFICIENT (kdis)

RESTRICTION
CONDITION IS CONSTANT

time

(e) SOC_chg_start SOC_chg_end (%)

SOC_chg_end

SOC_chg_start

RESTRICTION
CONDITION IS CONSTANT

0

time

(f) SOC_dis_start SOC_dis_end (%)

SOC_dis_start

SOC_dis_end

RESTRICTION
CONDITION IS CONSTANT

0

time

0  t11      t12 t13    t14          t15 t16    t17      t18

# FIG. 13

FIG. 14

FIG. 15

# FIG. 16

# FIG. 17

CELL #1: SMALL CAPACITY
CELL #2: LARGE CAPACITY
CELL #3: LARGE CAPACITY

CELL #n-2: LARGE CAPACITY
CELL #n-1: LARGE CAPACITY
CELL #n: LARGE CAPACITY

(a) Current (A)

0

CHARGING

DISCHARGING

time

(b) Voltage (V)

AVERAGE VOLTAGE (AVERAGE VALUE OF VOLTAGES OF CELL #1 TO CELL #n)

LARGE VOLTAGE (OCV) VARIATION

VOLTAGE OF CELL #1

SMALL VOLTAGE (OCV) VARIATION

time

(c) SOC (%)

AVERAGE SOC (AVERAGE VALUE OF SOCs OF CELL #1 TO CELL #n)

80

30

SMALL VOLTAGE (OCV) VARIATION

SOC OF CELL #1

0

LARGE VOLTAGE (OCV) VARIATION

time

EP 4 507 162 A1

FIG. 18

<div style="text-align:center">

**INTERNATIONAL SEARCH REPORT**

</div>

| International application No. |
|---|
| **PCT/JP2023/016036** |

**A.    CLASSIFICATION OF SUBJECT MATTER**

*H02J 7/02*(2016.01)i; *B60L 3/00*(2019.01)i; *B60L 50/60*(2019.01)i; *B60L 58/12*(2019.01)i; *B60L 58/16*(2019.01)i; *H01M 10/48*(2006.01)i; *H02J 7/00*(2006.01)i

FI:    H02J7/02 H; B60L3/00 S; B60L50/60; B60L58/12; B60L58/16; H01M10/48 P; H01M10/48 301; H02J7/00 P

According to International Patent Classification (IPC) or to both national classification and IPC

**B.    FIELDS SEARCHED**

Minimum documentation searched (classification system followed by classification symbols)

H02J7/02; B60L3/00; B60L50/60; B60L58/12; B60L58/16; H01M10/48; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | WO 2012/143996 A1 (HITACHI VEHICLE ENERGY, LTD.) 26 October 2012 (2012-10-26) paragraphs [0011]-[0079], fig. 1-12 | 1-10 |
| A | JP 2012-110221 A (HITACHI VEHICLE ENERGY, LTD.) 07 June 2012 (2012-06-07) paragraphs [0043]-[0064], fig. 9-11 | 1-10 |

☐ Further documents are listed in the continuation of Box C.       ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **06 July 2023** | **18 July 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/016036**

| Patent document cited in search report | | | Publication date (day/month/year) | Patent family member(s) | Publication date (day/month/year) |
|---|---|---|---|---|---|
| WO | 2012/143996 | A1 | 26 October 2012 | US 2014/0042973 A1 paragraphs [0053]-[0121], fig. 1-12 | |
| JP | 2012-110221 | A | 07 June 2012 | (Family: none) | |

Form PCT/ISA/210 (patent family annex) (January 2015)

**EP 4 507 162 A1**

**REFERENCES CITED IN THE DESCRIPTION**

**Patent documents cited in the description**

- JP 3528428 B